# EUROPEAN PATENT SPECIFICATION

(11) **EP 0 625 796 B1**
(45) Date of publication and mention of the grant of the patent: **05.08.1998**
(21) Application number: 94106850.4
(22) Date of filing: 02.05.1994
(51) Int. Cl.: H01L 21/60, H01L 21/48

(54) **Soldering method and apparatus for use in connecting electronic circuit devices**
Lötverfahren und Apparat zum Verbinden elektronischer Schaltungsanordnungen
Procédé de soudage et appareil pour la connexion de dispositifs à circuit électrique

(30) Priority: 18.05.1993 JP 115916/93
(43) Date of publication of application: 23.11.1994
(73) Proprietor: HITACHI, LTD., Chiyoda-ku, Tokyo 100 (JP)
(72) Inventor: Toru, Nishikawa, Yokohama-shi Kanagawa-ken (JP); Masahito, Ijuin, Fujisawa-shi Kanagawa-ken (JP); Ryohei, Satoh, Yokohama-shi Kanagawa-ken (JP); Mitsugu, Shirai, Kanagawa-ken (JP)
(74) Representative: Altenburg, Udo, Dipl.-Phys.

(56) References cited:
- EP-A- 0 518 774
- US-A- 5 090 609
- PATENT ABSTRACTS OF JAPAN vol. 16, no. 27 (E-1158) 23 January 1992 & JP-A-03 241 755 (HITACHI) 28 October 1991
- RESEARCH DISCLOSURE, no.259, November 1985, EMSWORTH,GB page 583 'a process to reduce tiw contact resistance with si'
- VLSI Electronics Microstructure Science vol.2
- ed. N.Einspruch pub. Acad. Press. '81 pgs.20-22.

## Description

### BACKGROUND OF THE INVENTION

The present invention relates to a method and an apparatus for fabricating an electronic circuit device and particularly, to a fluxless soldering method and apparatus for soldering at least two different materials or members of such circuit devices.

When two different materials or members are to be soldered together, it is usual to use flux or cream solder or solder paste containing flux to remove oxide films formed on surfaces of such members, maintain these surfaces clean by preventing oxidation thereof and promote wettability of solder on these surfaces. However, when such flux or flux-containing cream solder is used, there is a tendency of void generation due to evaporation of flux in soldering operation, which causes strength and hence reliability of soldered junction to be lowered.

Further, in such conventional technique, there is an environmental pollution problem, particularly, such as destruction of ozone layer, due to removal of flux since flux must be washed out by using organic solvent such as chloric solvent or freon after the soldering is completed. Further, it is very difficult to completely wash out flux although not impossible.

In order to solve such problem, various soldering methods requiring no flux have been proposed. For example, Japanese Patent Application Laid-open (Kokai) Nos. S58-3238 and H3-171643 with corresponding family member US-A-5 090 609 disclose methods each of which comprises the steps of setting a member carrying solder bumps or solder balls and a member having bonding pads or bonding faces, removing oxide films and/or contamination on surfaces of the solder balls and the pads by irradiating them with ion beam, aligning these members and bonding them by heating and melting the solder balls, all of these steps being performed in vacuum. In another example disclosed in Japanese Patent Application Laid-open (Kokai) No. H3-241755, contamination layers and oxide layers on surfaces of members to be bonded together and solder balls are removed by sputter-etching with atom or ion. Then, these members are aligned in an oxidizing atmosphere and solder bumps are melted by heating to achieve the bonding.

In these conventional methods, since the sputter-etching step is performed while estimating time necessary to remove oxide film on solder balls, it is impossible to remove the oxide films on the surfaces of the solder balls correspondingly to actual thickness thereof. Further, in the former two methods in which all of the steps are performed in vacuum, the workability and producibility are low and, when a device for alignment is provided in a vacuum chamber, the size of the latter becomes large necessarily, in which case, the vacuum chamber tends to be contaminated since gas adsorbed in an inner wall of the vacuum chamber is hardly discharged externally, and an apparatus itself for performing the same method becomes high cost.

VLSI Electronics Microstructure Science vol. 2 ed. Einspruch, pub. Acad. Press '81, pgs 20-22 discloses end point detection in semiconductor device etching procedures.

### SUMMARY OF THE INVENTION

An object of the present invention as claimed in claims 1 and 3 is to provide a method of soldering members without using flux and an apparatus for performing the same method.

Another object of the present invention is to provide such fluxless soldering method in which an alignment of members can be performed in atmospheric, oxidizing atmosphere and an apparatus for performing the same method.

A further object of the present invention is to provide, a fluxless soldering method, a method and apparatus for removing oxide film on solder balls by sputter-etching according to thickness of oxide film thereon.

In order to achieve the above mentioned objects, according to the present invention, the soldering methods comprises the steps of:
detecting at least one substance emitted from the solder balls by atom or ion sputter-etching, determining whether or not the detected substance is from oxide layer on a surface of the solder ball or from the solder ball itself and removing the oxide film on the solder ball by controlling the sputter-etching according to a result of determination;
aligning members to be soldered in an oxidizing atmosphere; and
heating the members in non-oxidizing atmosphere.

Further, in the above mentioned objects, the apparatus according to the present invention comprises:
means for removing oxide film on a soldering ball by detecting at least one substances emitted from the solder ball by atom or ion sputter-etching, determining whether the detected substance is from the oxide layer on a surface of the solder ball or from the solder ball itself and controlling the sputter-etching according to a result of determination;
means for aligning members to be soldered in an oxidizing atmosphere; and
heating means for heating solder balls on the members in non-oxidizing atmosphere.

### BRIEF DESCRIPTION OF THE DRAWINGS

Fig. 1 is a block diagram showing a construction of a soldering apparatus for soldering electronic circuits, according to the present invention;
Fig. 2 is a flowchart showing a fluxless soldering method according to the present invention;
Fig. 3 illustrates soldering steps of a fluxless soldering method according to the present invention;
Fig. 4 is a graph showing thickness of oxide film on a solder ball formed by the soldering apparatus of the present invention, in comparison with that formed by a conventional apparatus;
Fig. 5 is cross sectional views showing surface oxidation of solder ball and soldered state according to difference in sputter-etching condition;
Fig. 6 is a block diagram showing a sputter-cleaning control means according to the present invention;
Fig. 7 is a graph showing thickness of oxide film on a surface of solder ball monitored according to the present invention;
Fig. 8 shows steps of forming solder balls on a printed circuit board, according to the present invention;
Fig. 9 shows thickness of oxide film on a surface of solder ball with time for which it is disposed in atmosphere and solderbility thereof;
Fig. 10 shows thickness of oxide film on a surface of solder ball with oxygen concentration during heating and melting of solder ball;
Fig. 11 is a perspective view of a substrate and its roof; and
Fig. 12 shows steps of soldering the roof to the substrate, according to the present invention.

### DETAILED DESCRIPTION OF THE PREFERRED EMBODIMENTS

The inventors of this invention had studied a fluxless soldering method and apparatus in view point of removal of oxide film on a solder ball by means of sputter-etching according to variation of thickness thereof.

In the conventional methods disclosed in the previously mentioned Kokai Nos. S58-3238, H3-171643 and H3-241755, the sputter-etching for removing oxide film on the solder ball is terminated when a previously estimated removing time lapses regardless of unavoidable variation in thickness of the oxide film. In such method, the following defects may occur:
(a) There may be residual oxide film on the solder ball which is left unetched. In such case, breakage of oxide film which will be newly formed hardly occurs when solder ball is expanded by heat applied for melting it. Even if it is broken, such residual oxide film will prevent the solder from wetting. Further, there may be fault connection since a formation of bonding configuration of soldering material to be achieved by surface tension of molten soldering material, such as meniscus of filet, spherical segment in flip-chip connection and self-alignment, is disturbed by surface oxide film; and
(b) When a portion of soldering material is lost by over sputter-etching, similar fault of connection to that mentioned in (a) may occur. It has been found that this phenomenon occurs due to the facts that, since there is difference in etching rate between a plurality of intermetallic compounds co-existing in the soldering material, surface of the soldering material becomes irregular and surface area of the soldering material becomes large and tends to be oxidized and that, since an amount of soldering material structure around the intermetallic compounds having low etching rate is reduced, melting rate of these compounds is lowered and hence melting of surface portion thereof is insufficient, rigidity of soldering material is increased and hence fluidity thereof is reduced. That is, according to the method in which oxide film removing time is preliminarily estimated and, when the estimated time lapses, the sputter-etching is terminated, as in the previously mentioned conventional techniques, it is impossible to remove oxide film on a surface of a soldering material correspondingly to thickness variation of oxide film.

From the result of analysis mentioned above, the inventors of this invention have concluded that, if it is possible to determine whether sputter-etching is currently performed for oxide film and/or contamination on surface of a soldering material or the soldering material itself and if it is possible to stop sputter-etching at a suitable time instance, there is no residual oxide film left unetched due to under-etching or there is no loss of soldering material due to over-etching, so that oxide film on the surface of the soldering material can be removed according to thickness variation of the oxide film on the soldering material.

It has been known that material is etched away by bombardment of atom or ion having kinetic energy directed thereto and that, due to such bombardment of atom or ion, substance such as secondary atom, secondary ion, photon (characteristic X ray) or secondary electron, which is specific to the material, are emitted therefrom. Since the amount of substance is specific to individual materials, it is possible to control the sputter-etching by detecting an amount of emitted substance and determining whether the detected substance is from oxide film on the soldering material or from constituents of the soldering material. Phenomenon of emission of such as secondary atom, secondary ion, photon (characteristic X ray), secondary electron by sputter-etching will be described in detail. In sputter-etching, when atom of a solid material is bombarded with incident particle having energy, the atom is energized thereby and emitted as secondary atom or secondary ion. For atom which constitute a solid material which is not sputter-etched, it becomes excited state by energy of incident particle. In the latter case, the atom tends to return from the unstable excited state to a stable ground state by emitting photon (characteristic X ray) or secondary electron.

The bonding method according to the present invention will be described in detail.

The soldering methods comprises the steps of:
detecting at least one substance emitted from the solder ball by atom or ion sputter-etching, determining whether the detected substance is from oxide layer on a surface of the solder ball or from the solder ball itself and removing the oxide film on the solder ball by controlling the sputter-etching according to a result of determination;
aligning members to be soldered in an oxidizing atmosphere; and
heating the members in non-oxidizing atmosphere.

The substance emitted from material in the present invention may be any so long it is substance specific to the material. Examples of such substance include secondary atom, secondary ion, photon (characteristic X ray) or secondary electron.

The detection of substance in the present method is performed for at least one of secondary atom, secondary ion, photon (characteristic X ray) and secondary electron.

The soldering material used in the present method may be any soldering material. Examples of such soldering material include alloys of Pb and Sn, alloys of Sn and Ag, alloys of Au and Sn, alloys of Au and Ge, alloys of Au and Si and any combination thereof.

The non-oxidizing atmosphere in the present method may be any non-oxidizing atmosphere. Examples thereof include inert gas, reducing gas, fluorinate vapor or active gas atmosphere. Inert gas includes nitrogen gas, argon gas, helium gas and active gas may be selected from (1) mixture of hydrogen gas and nitrogen gas and (2) hydrogen gas.

Further, the soldering apparatus for use in connecting electronic circuits, according to the present invention comprises:
means for removing oxide film on a solder ball by detecting at least one substance emitted from the solder balls by atom or ion sputter-etching, determining whether or not the detected substance is from oxide layer on a surface of the solder ball or from the solder ball itself and controlling the sputter-etching according to a result of determination;
means for aligning members to be soldered in an oxidizing atmosphere; and
heating means for heating solder balls on the members in non-oxidizing atmosphere.

The removing means includes means for detecting at least one substance emitted specifically from the solder balls by atom or ion sputter-etching, such as at least one of secondary atom, secondary ion, photon (characteristic X ray) and secondary electron, and can remove reliably and in proper quantity the oxide film on the surface of the solder ball by controlling the sputter-etching. The aligning means performs an alignment in oxidinzing atmosphere, so that an apparatus and process therefor can be simplified. The heating means includes evacuation means and means for supplying non-oxidizing gas, for controlling purity of heating gas, that is, impurity gas concentration of the heating gas. The heating means further includes a prenum chamber, a heating and melting chamber and a cooling chamber which are partitioned by partition walls and selectively in communication with each other by gate valves provided in the partition walls. With such construction, gas and/or water content, etc., adsorbed by members to be bonded together is removed in the prenum chamber, so that degradation of purity of atmospheric gas in the heating and melting chamber can be prevented.

Substance emitted, detection of the substance, soldering material and non-oxidizing atmosphere to be used in the soldering apparatus are the same as those described with respect to the soldering method according to the present invention.

Preferred embodiments of the present invention will be described in detail with reference to the drawings.

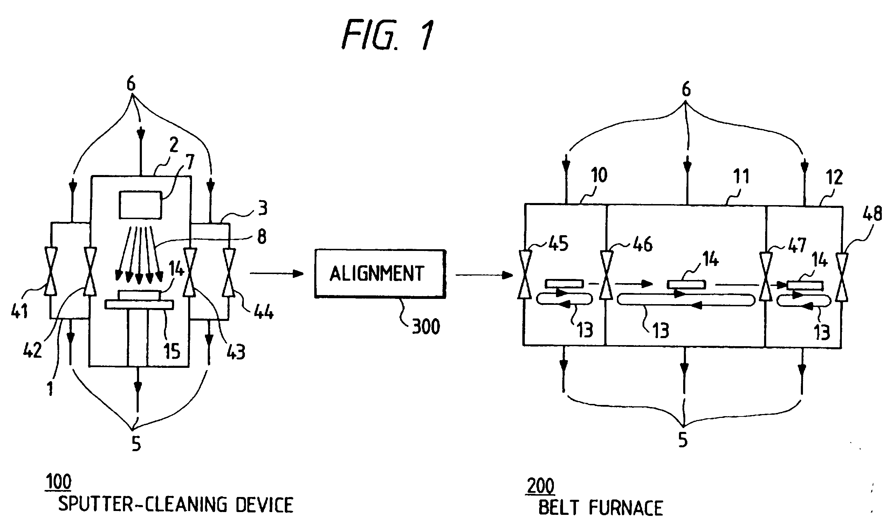

Fig. 1 shows a construction of a fluxless soldering apparatus according to an embodiment of the present invention. In Fig. 1, a sputter-cleaning device 100 includes a prenum chamber 1, a cleaning chamber 2 and an outlet chamber 3, all of which are evacuated and adjacent ones of which can be selectively communicated through gate valves 42 and 43, respectively. Further, a gate valve 41 is provided in an inlet of the prenum chamber 1 and a gate valve 44 is provided in an outlet of the outlet chamber 3.

Each chamber is associated with an evacuating system 5 and a gas introducing system 6 and, in both the prenum chamber 1 and the outlet chamber 3, gas purge is performed by evacuation and subsequent communication to atmosphere.

In the cleaning chamber 2, evacuation and gas supply to a gun 7 provided therein to emit ion and/or atom are performed.

Solder portions, that is, solder balls or solder bumps, and connecting pads, etc., of a member 14 transported into the sputter-cleaning device 100 and put on a sample table 15, which are to be bonded together, are irradiated with ion or atom beam 8 to remove oxide films and/or organic contamination films.

The cleaning chamber 2 can treat a plurality of mutually connected connecting members simultaneously.

The member 14 thus cleaned is transported to the alignment mechanism 300 and, after alignment, transported to the belt furnace 200.

The transportation of the member 14 from the sputter cleaning device 100 through the alignment mechanism 300 to the belt furnace 200 is continuously performed by means of belt conveyors.

The belt furnace 200 comprises a prenum chamber 10, a heating and welding chamber 11 and a cooling chamber 12, all of which can be evacuated and between adjacent ones of which are connected by gate valves 46 and 47. Further, a gate valve 45 is provided in an inlet of the prenum chamber 10 and a gate valve 48 is provided in an outlet of the cooling chamber 12.

Each chamber is associated with an evacuating system 5 and a gas introducing system 6 and, in both the prenum chamber 1 and the outlet chamber 3, gas purge is performed by evacuation and subsequent introduction of non-oxidizing gas.

The member 14 in the belt furnace 200 is transported through the respective chambers 10, 11 and 12 by belt conveyors 13 provided therein, respectively.

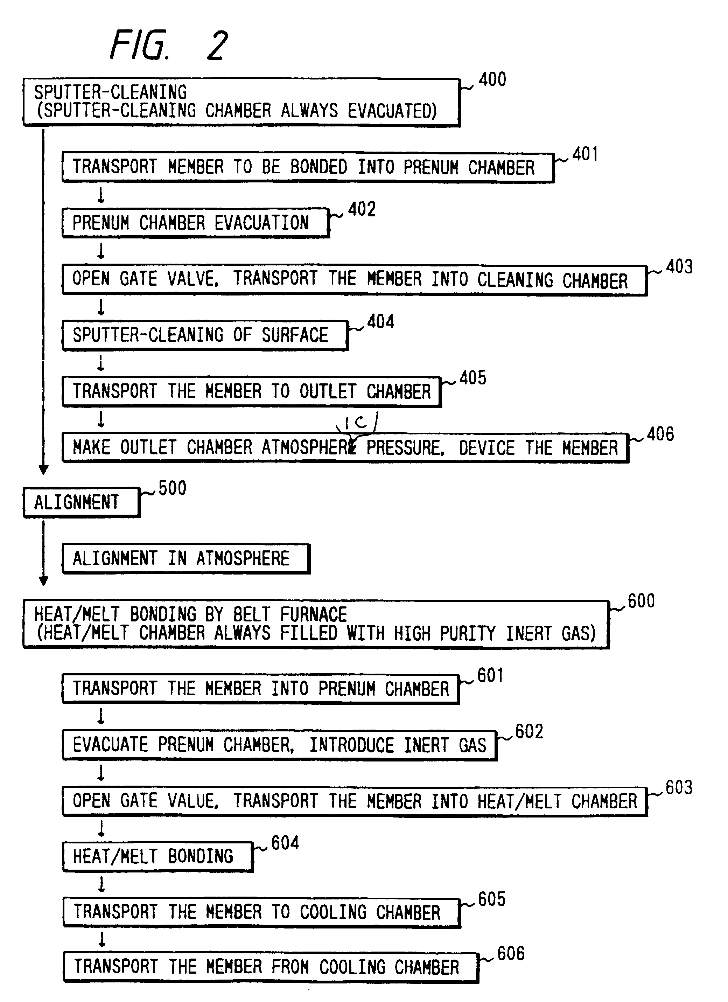

Fig. 2 shows a flowchart of a fluxless soldering operation by means of the apparatus shown in Fig. 1. In an initial stage, all of the gate valves 41 to 48 are closed.

In a step 400 in Fig. 2, oxide film and/or organic contaminating film on bonding pads of the member 14 and on the solder portions is removed by the sputter-cleaning device 100. The step 400 includes steps 401 to 406. The cleaning chamber 2 is continuously evacuated so that vacuum pressure of 10⁻⁵ Torr or higher is maintained therein.

In the step 401, the gate valve 41 of the inlet of the prenum chamber 1 of the sputter cleaning device 100 is opened to convey the member 14 having solder bumps at predetermined positions thereof into the prenum chamber 1. In the step 402, the prenum chamber 1 is evacuated. When an amount of gas and/or water content adsorbed by the member 14 such as printed circuit board, etc., is much, heating is performed additionally simultaneously with the evacuation of the prenum chamber 1, to thereby prevent vacuum condition in the subsequent cleaning chamber 2 from being degraded. It may be possible to reduce a processing time in the cleaning chamber 2 by providing a baking device in a preceding position with respect to the prenum chamber 1. The baking device may perform evacuation and heating.

Then, in the step 403, the gate valve 42 between the prenum chamber 1 and the cleaning chamber 2 is opened through which the member 14 is transported into the cleaning chamber 2. Thereafter, the gate valve 42 is closed. Then, in the step 404, the member 14 in the cleaning chamber 2 is irradiated with ion or atom beam 8 from the gun 7 while being rotated to remove undesired films on the solder balls and the connecting pads to sputter-clean surfaces thereof.

In the step 405, the outlet side gate valve 43 of the cleaning chamber 2 is opened and the thus cleaned member 14 is transported into the outlet chamber 3 maintained at vacuum pressure and then the latter gate valve 43 is closed.

Thereafter, in the step 406, the outlet chamber 3 is made atmospheric pressure and its outlet side gate valve 44 is opened through which the member 14 is derived therefrom.

Then, in a step 500, an alignment between two members 14 thus processed is performed by means of the alignment mechanism 300 in atmospheric environment.

Then, in a step 600, the fluxless soldering is performed by the belt furnace 200. The step 600 includes steps 601 to 606. It should be noted that the interior of the heating and welding chamber 11 is continuously filled with highly pure non-oxidizing atmosphere by evacuation and subsequent introduction of non-oxidizing gas.

In the step 601, the inlet side gate valve 45 of the prenum chamber 10 is opened through which the aligned members 14 are introduced thereinto. In the step 602, the prenum chamber 10 is evacuated and then filled with highly pure non-oxidizing gas.

Then, in the step 603, the gate valve 46 between the prenum chamber 10 and the heating and soldering chamber 11 is opened to move the members 14 to the latter and, in the step 604, the gate valve 46 is closed and heating of the bonding portions of the members 14 is performed.

Thereafter, in the step 605, the gate valve 47 between the heating and melting chamber 11 and the cooling chamber 12 is opened, through which the soldered members 14 are transported to the cooling chamber 12 which is filled with highly pure inert gas. After cooling, in the step 606, the cooling chamber 12 is made atmospheric pressure and then the bonded members 14 are derived therefrom through the gate valve 48 opened at that time.

Since concentration of impurity gas in the highly pure inert gas atmosphere can be selected arbitrarily on the basis of vacuum pressure to be established therein and purity of the inert gas to be introduced thereinto, it is possible to set an optimum fluxless bonding condition for any of combinations of various soldering material and members to be bonded.

When a solder material containing, for example, Sn which exhibits superior wettability is used, it is possible to perform a fluxless soldering by removing the prenum chamber 10 and the cooling chamber 12 and filling the heating and melting chamber 11 with inert gas such as nitrogen gas, argon gas or helium gas.

Further, it is possible to further reduce concentration of residual oxygen by introducing hydrogen gas into the inert gas to allow reaction between hydrogen gas thus introduced and residual oxygen to occur.

Alternatively, it may be possible to remove the evacuation systems of the belt furnace and, instead thereof, use a belt furnace in which atmospheric gas therein is substituted by such inert gas.

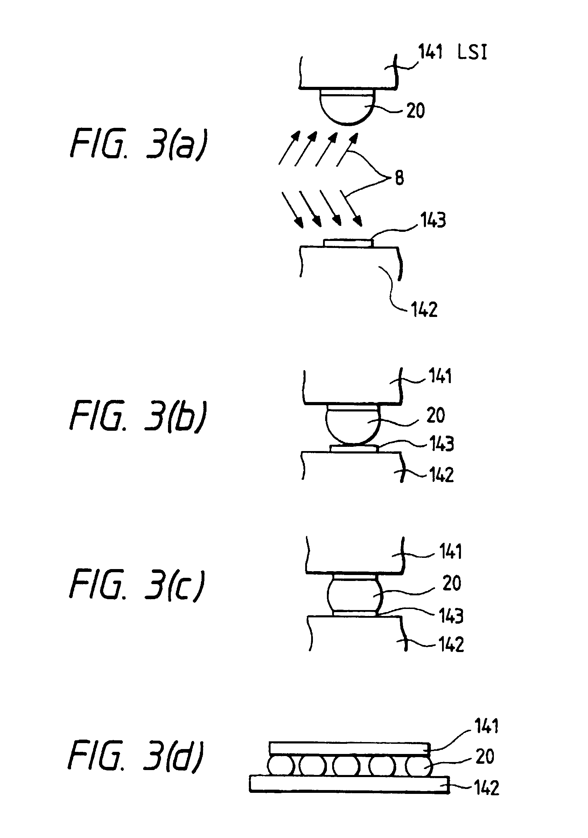

Fig. 3 illustrates the process of melting and soldering of the solder ball in the present invention.

As shown in Fig. 3(a), oxide films and contamination layers on a plurality of solder balls 20 (only one of them is shown) on an LSI 141 and a bonding pad 143 on a ceramic substrate 142 are removed first by irradiating them with particle beam 8 of such as Ar atom in the sputter-cleaning device 100.

Then, after the solder ball 20 and the bonding pad 143 are aligned with each other in atmosphere as shown in Fig. 3(b), they are heated in the belt furnace 200 so that they are melt-bonded as shown in Fig. 3(c). Thus, the LSI 141 and the ceramic substrate 142 are bonded together through a plurality of the solder balls 20 as shown in Fig. 3(d).

Any of usually used soldering materials such as Pb5Sn, Sn3.5Ag, Sn37Pb, Au12Ge, etc., can be used as the material of the solder ball 20 and the belt furnace 200 may be filled with an inert gas of a mixture of hydrogen gas and nitrogen gas in a ratio of 1:1 or 1:3. The ratio of hydrogen gas and nitrogen gas can be set suitably according to the soldering condition.

The solder ball 20 is formed on the LSI 141 through a similar process to that mentioned above.

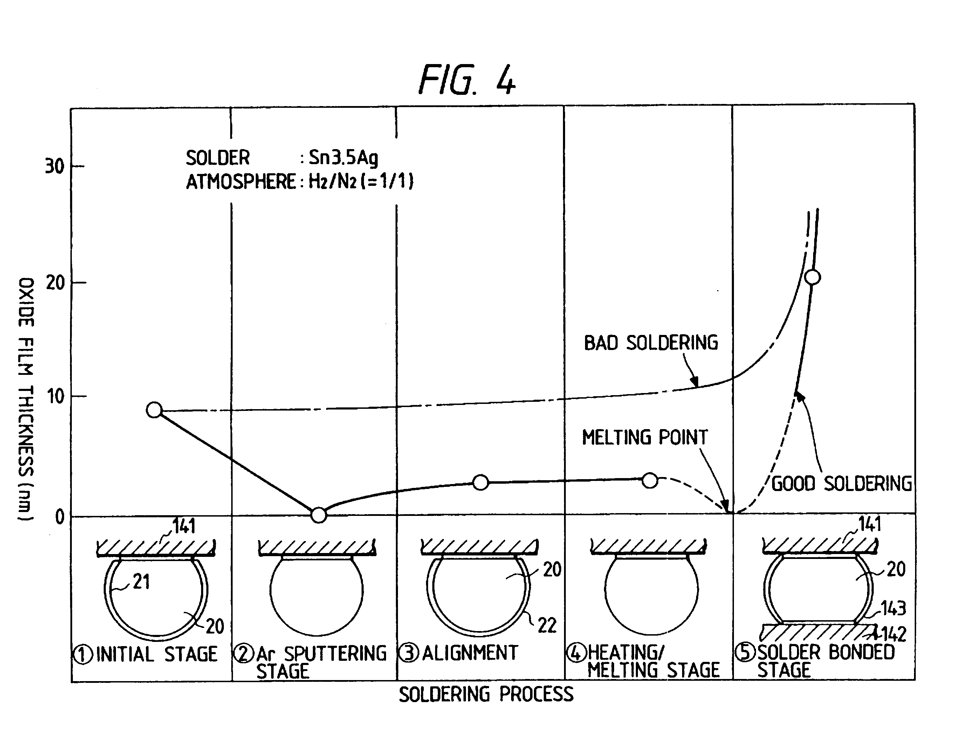

A solid line in Fig. 4 shows data of an example of change of thickness of oxide film on the solder ball 20 in the above mentioned process.

In an initial stage (1) in Fig. 4, the solder ball 20 is covered by a thick oxide and/or contamination film 21.

In a next stage (2), the thick oxide and/or contamination film 21 is removed by the sputter-cleaning and the initial oxide film thickness of about 10 nm is reduced to almost zero.

In a stage (3), an oxide film 22 is formed again on the surface of the solder ball 20 due to the alignment in atmosphere. Since. in this stage, the solder ball 20 is not heated, growing rate of the oxide film 22 is low and thickness thereof is restricted to 2 - 3 nm or thinner.

When the sample in the stage (3) is heated in the belt furnace 200, the solder ball 20 is melted and expanded and the oxide film 22 thereon is fractured thereby to expose the solder ball as shown in a stage (4) in Fig. 4.

In a stage (5), the LSI 141 and the ceramic substrate 142 are bonded together by the solder ball melted in the stage (4). Due to the heating of the solder ball to melt it, a relatively thick oxide film is formed on a surface of the solder ball after solidified.

A chain line in Fig. 4 shows a characteristics of the solder ball when the sputter-cleaning process is not performed therefor. Since, in such case, the initial thick oxide film is left as it is, fault connection occurs frequently in the melting process in the stage (4).

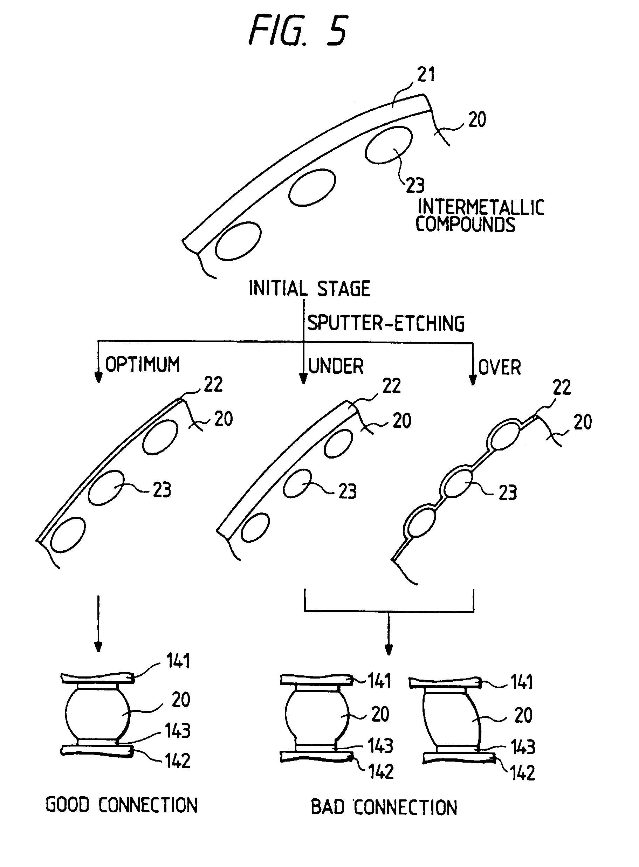

Fig. 5 illustrates surface oxidation and connecting solder configuration, which depend upon sputter-etching condition.

When the sputter-cleaning is not performed for the oxide film of the solder surface or when the sputter-cleaning performed for the oxide film is under as shown in Fig. 4, fault connection such as insufficient formation of spherical segment of solder ball and insufficient self-alignment, etc., occurs due to thick oxide film.

Further, when intermetallic compounds 23 co-exist in a solder of such as Sn3Ag, similar fault connection may occur if over sputter-etching is performed. When over sputter-etching is performed, surface of the soldering material becomes irregular since surfaces of intermetallic compounds 23 whose etching rate is lower than those surrounding the intermetallic compounds are exposed. Since oxidation proceeds along the irregular surface and melting rate of the intermetallic compounds is lowered due to reduced amount of solder structure around the intermetallic compounds, the intermetallic compounds 23 can not be melted sufficiently. As a result, rigidity of solder surface is increased and restoring force of molten solder material to the spherical segment configuration due to surface tension is reduced. Thus, there may be fault bonding configuration produced.

In order to obtain such good bonding configuration of solder as shown in Fig. 5, means is required for in-process-monitoring and controlling sputter-etching of solder ball to reliably remove oxide film thereon without over-etching.

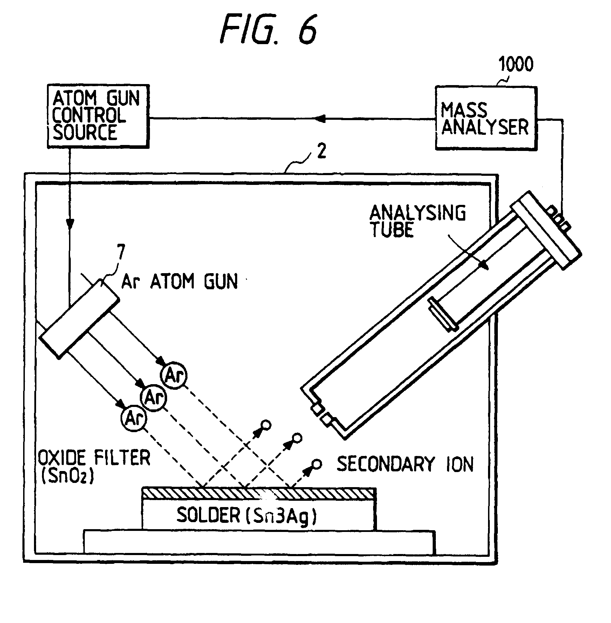

Fig. 6 is a block diagram of a sputter-cleaning control apparatus according to the present invention. As shown in Fig. 6, a sputter-etching in-process monitoring device 1000 having such device as quadrupole mass analyser for detecting secondary ion generated by sputter-etching and an analysing tube is associated with the sputter-cleaning chamber 2 shown in Fig. 1 to detect an end point of etching of oxide film.

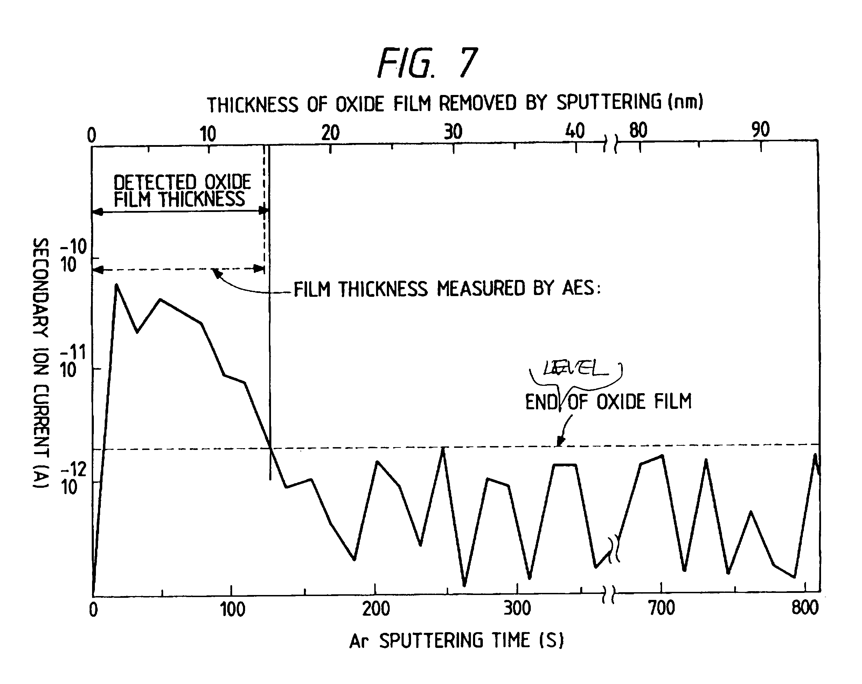

Fig. 7 shows an example of monitored result of a surface oxide film on a solder, according to the present invention, which is obtained by performing an in-process monitoring of sputter-etching to detect secondary ion generated from a surface oxide film (SnO, SnO₂) on a Sn3Ag solder by sputter-etching. As shown in Fig. 7, an amount of secondary ion detected is large for a portion corresponding to oxide film and small for solder matrix portion.
Therefore, it is possible to detect an end of sputter-etching of oxide film. That is, by controlling the sputter-etching such that it is terminated when the amount of secondary ion detected becomes an end level of oxide film or lower, it is possible to reliably remove the oxide film without over-etching.

With this scheme, it is possible to obtain a good bonding even for a solder in which intermetallic compound such as Sn3Ag co-exists.

Although, in the embodiment, secondary ion is detected, it is possible to perform the in-process monitoring and control of sputter-etching by detecting secondary electron, photon or neutral atom, etc., generated when oxide film is sputter-etched.

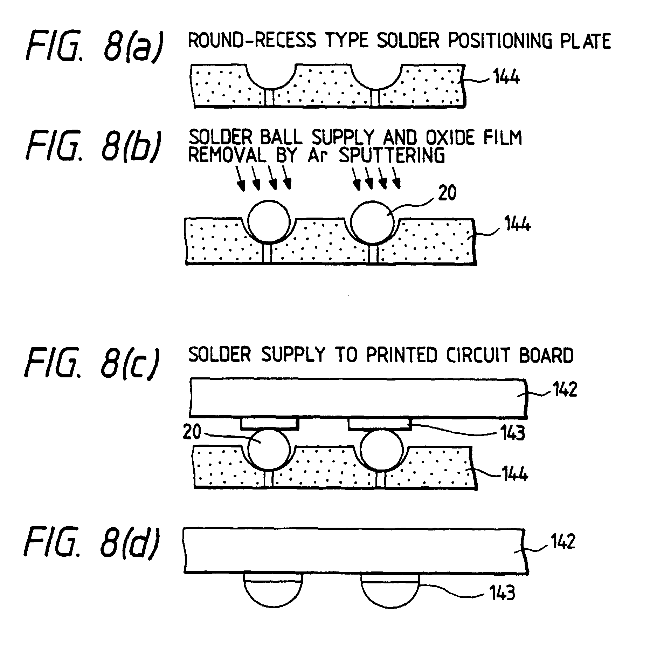

Fig. 8 illustrates steps of forming solder balls on bonding pads of an LSI and a substrate, etc.

First, as shown in Fig. 8(a), a positioning plate 144 of such as glass fiber which has recesses at positions of respective solder balls 2 is prepared. A number of solder balls 2 are supplied onto the plate 144 and allowed to rotate, so that these solder balls 2 are received in the respective recesses as shown in Fig. 8(b). Then, these solder balls 20 in the recesses are irradiated with such as Ar atom beam to remove oxide films thereon.

Then, as shown in Fig. 8(c), a printed circuit board 142 is put thereon with alignment between these solder balls and pads 143 of the circuit board 142 and, by heating them, the solder balls 20 are welded to the respective pads 143 as shown in Fig. 8(d).

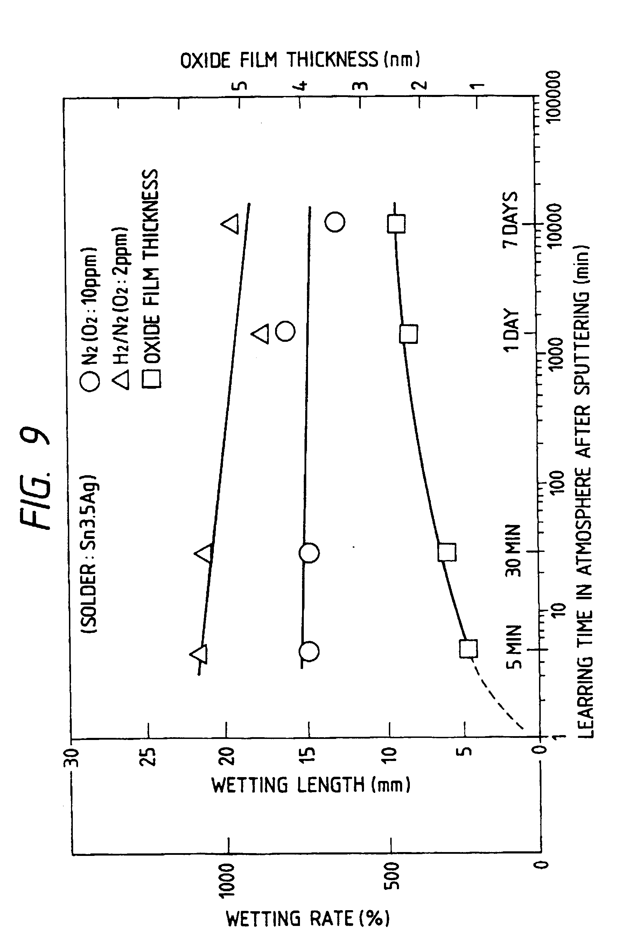

Fig. 9 shows curves obtained by measuring a variation of thickness of oxide film 22 on the respective solder balls 20 atom-sputtered and left in atmosphere.

It is clear from Fig. 9 that, although thickness of oxide film becomes 1 nm after it is left for several minutes lapses in atmosphere, increase of thickness of oxide film for several days thereafter is limited in a range from 2 nm to 3 nm.

As mentioned with respect to Fig. 4, it is possible to perform the heating and melting process in the belt furnace in Fig. 1 so long as thickness of oxide film is 2 to 3 nm or smaller.

The curves in Fig. 9 marked by circular spots and triangle spots are wetting length and wetting rate of solder plotted for identical solder pellets which are heated and welded to pad surfaces similarly sputter-cleaned in the belt furnace 200 shown in Fig. 1 with using nitrogen gas or a mixture of hydrogen gas and nitrogen gas as gas filling the furnace, respectively. As is clear from Fig. 9, although the wetting length and wetting rate characteristics are reduced slightly with time for which it is put in atmosphere, the wettability thereof is still acceptable even after exposition in atmosphere for 7 days and thus it is possible to obtain a good bonding without using flux.

Since it can be said from Fig. 9 that it takes much more time when the thickness becomes 5 nm which may be practical upper limit, there is no need of limiting the time for which the solder material can be put in atmospheric condition after sputter-cleaned.

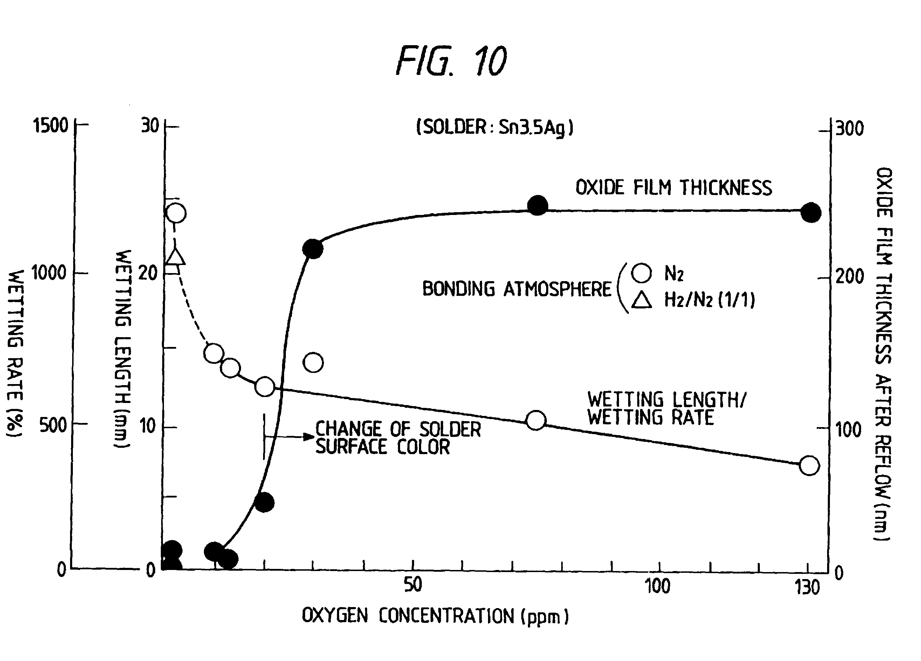

Fig. 10 shows plots of the thickness of oxide film on the solder ball of Sn3.5Ag and the wetting rate and the wetting length thereof when soldered in the belt furnace 200 with respect to oxygen concentration in the furnace.

When oxygen concentration exceeds 20 ppm, the oxide film thickness increases abruptly beyond 200 nm. Further, the wetting rate and wetting length are reduced remarkably until oxygen concentration reaches 20 ppm. Beyond 20 ppm, solder surface changed in color to light violet and became useless practically.

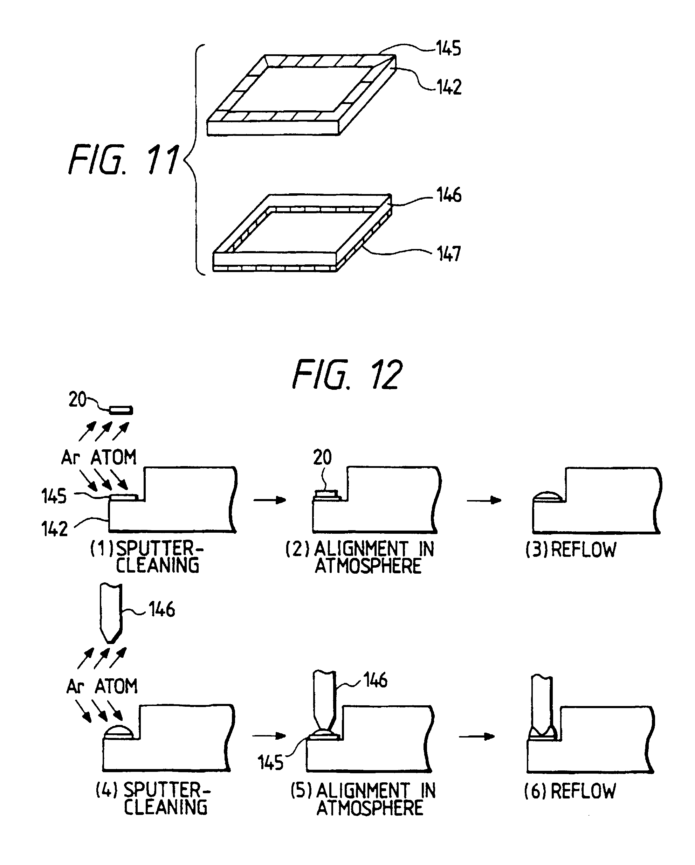

Now an embodiment of the present invention will be described with reference to Fig. 11, in which a roof plate 147 having a frame 146 is bonded to a substrate 142 having metallized portion 145.

As shown by (1) in Fig. 12, the metallized portion 145 and a solder 20 are sputtered with Ar atom and the solder 20 whose oxide film is thus removed is put on the metallized portion 145 as shown by (2) in Fig. 12. Then, as shown by (3) in Fig. 12, the solder 20 is melted in non-oxidizing atmosphere to form a solder ball by reflow.

Thereafter, the frame 146 and the solder ball on the metallized portion 145 are atom/ion-sputtered again as shown by (4) in Fig. 12, the frame 146 is aligned with the metallized portion 145 in atmospheric environment as shown by (5) in Fig. 12 and then they are soldered in non-oxidizing atmosphere as shown by (6) in Fig. 12.

In the present invention in which oxide film and/or contamination film on the surfaces of the solder on the members to be bonded and the pads is sputter-cleaned and then alignment is performed in atmospheric environment, there is no need of providing any aligning device in vacuum environment. Since, therefore, the heat and melt bonding can be done without using a universal belt furnace, the workability and producibility, etc., can be improved considerably.

Further, since the sputter-etching can be monitored and controlled in process, it is possible to reliably remove the oxide film and/or contamination film while preventing over-etching and to perform a good bonding without degrading restoring force of the solder due to surface tension.

Further, since the oxide film and/or contamination film on the solder surface and the pad surface can be removed mechanically, the sputter-cleaning device may be omitted or the number of sputter-cleaning steps may be reduced, resulting in improved efficiency of bonding process.

In addition, it is possible to set the solder bonding condition optimum by controlling concentration of non-oxidizing or reducing gas in the heat and melt device.

Finally, it is possible to improve an operational efficiency of electronic circuit connecting device by transporting the members to be bonded by a belt conveyor.

## Claims

1. A method of soldering in fabricating an electronic circuit device, including:
a process for removing an oxide layer from a surface of a soldering material (20) provided for bonding members (141) to a circuit substrate (142),
a process for aligning said members (141) and said circuit substrate (142) in an atmosphere, and
a process for heating said soldering material (20) between said members (141) and said circuit substrate (142) in a non-oxidizing atmosphere or a reducing atmosphere and bonding said members (141) and said circuit substrate (142) by fluxless soldering,
**characterized in that**
said process for removing said oxide layer is an atom or ion sputter-etching process, and
said sputter-etching process is terminated after detecting a change in particle emittance from said soldering material (20) due to said sputter-etching process.

2. The method claimed in claim 1, further characterized in that said particle emitted is at least either secondary atom, secondary ion, photon, or secondary electron; and said sputter etching process is terminated when the amount of said emitted particles detected is lower than the end level of said oxide layer.

3. A soldering apparatus for fabricating an electronic circuit device, including:
a sputter-etching device (100) to remove an oxide layer from a surface of a soldering material (20) provided for bonding members (141) to a circuit substrate (142);
an aligning structure (300) to align said members (141) and said circuit substrate (142) in an atmosphere, and
a heating device (200) incorporating said members (141) and said circuit substrate (142) aligned previously and heating said soldering material (20) between said members (141) and said circuit substrate (142) in a non-oxidizing atmosphere or a reducing atmosphere and bonding said members (141) and said circuit substrate (142) by fluxless soldering,
**characterized in that**
said sputter-etching device (100) comprises
means (1000) for detecting a particle emittance from said soldering material (20) due to sputter-etching, and
means for terminating sputter-etching when the detected amount of said particles reached a predetermined level.

## Patentansprüche

1. Lötverfahren beim Herstellen eines elektronischen Schaltungselements, aufweisend:
einen Prozeß zum Entfernen einer Oxidschicht von einer Oberfläche eines Lötmaterials (20), das zum Bonden von Elementen (141) an ein Schaltungssubstrat (142) vorgesehen ist,
einen Prozeß zum Ausrichten der Elemente (141) und des Schaltungssubstrats (142) in einer Atmosphäre und
einen Prozeß zum Erhitzen des Lötmaterials (20) zwischen den Elementen (141) und dem Schaltungssubstrat (142) in einer nicht-oxidierenden Atmosphäre oder einer reduzierenden Atmosphäre und zum Bonden der Elemente (141) und des Schaltungssubstrats (142) durch flußmittelfreies Löten,
**dadurch gekennzeichnet,** daß
der Prozeß zum Entfernen der Oxidschicht ein Atom- oder Ionen-Sputter-Ätz-Prozeß ist und
der Sputter-Ätz-Prozeß nach Detektieren einer Änderung in der Partikel-Emittanz von dem Lötmaterial (20) aufgrund des Sputter-Ätz-Prozesses beendet wird.

2. Verfahren gemäß Anspruch 1, weiter dadurch gekennzeichnet, daß das emittierte Partikel mindestens ein Sekundäratom, Sekundärion, Photon oder Sekundärelektron ist; und daß der Sputter-Ätz-Prozeß beendet wird, wenn die Menge der detektierten emittierten Partikel geringer ist als das Endniveau der Oxidschicht.

3. Lötvorrichtung zum Herstellen eines elektronischen Schaltungselements, aufweisend:
eine Sputter-Ätz-Einrichtung (100) zum Entfernen einer Oxidschicht von einer Oberfläche eines Lötmaterials (20), das zum Bonden von Elementen (141) an ein Schaltungssubstrat (142) vorgesehen ist;
eine Ausrichtstruktur (300) zum Ausrichten der Elemente (141) und des Schaltungssubstrats (142) in einer Atmosphäre und
eine Heizeinrichtung (200), welche die zuvor ausgerichteten Elemente (141) und das Schaltungssubstrat (142) aufnimmt und das Lötmaterial (20) zwischen den Elementen (141) und dem Schaltungssubstrat (142) in einer nicht-oxidierenden Atmosphäre oder einer reduzierenden Atmosphäre erhitzt und die Elemente (141) und das Schaltungssubstrat (142) durch flußmittelfreies Löten bondet,
**dadurch gekennzeichnet,** daß
die Sputter-Ätz-Einrichtung (100) aufweist:
Mittel (1000) zum Detektieren einer Partikel-Emittanz von dem Lötmaterial (20) aufgrund Sputter-Ätzens und
Mittel zum Beenden des Sputter-Ätzens, wenn die detektierte Menge der Partikel ein vorbestimmtes Niveau erreicht hat.

## Revendications

1. Un procédé de soudage en fabrication d'un dispositif de circuit électronique, comprenant :
un processus pour retirer une couche d'oxyde d'une surface d'un matériau de soudage (20) prévu pour solidariser des organes (141) à un substrat de circuit (142),
un processus pour aligner les organes (141) et le substrat de circuit (142) dans une atmosphère, et
un processus pour chauffer le matériau de soudage (20) entre les organes (141) et le substrat de circuit (142) dans une atmosphère non oxydante ou une atmosphère réductrice et solidariser les organes (141) et le substrat de circuit (142) par soudage sans flux,
caractérisé en ce que
le processus pour retirer la couche d'oxyde est un processus de gravure par pulvérisation cathodique atomique ou ionique, et
il est mis fin au processus de gravure par pulvérisation cathodique après détection d'un changement d'émittance de particule depuis le matériau de soudage (20) du fait du processus de gravure par pulvérisation cathodique.

2. Le procédé revendiqué dans la revendication 1, caractérisé en outre en ce que ladite particule émise est au moins soit un atome secondaire, un ion secondaire, un photon ou un électron secondaire ; et il est mis fin au processus de gravure par pulvérisation cathodique lorsque la quantité de ces particules émises détectée est inférieure au niveau final de la couche d'oxyde.

3. Un dispositif de soudage pour la fabrication d'un composant de circuit électronique, comprenant :
un dispositif de gravure par pulvérisation cathodique (100) pour retirer une couche d'oxyde d'une surface d'un matériau de soudage (20) prévu pour solidariser des organes (141) à un substrat de circuit (142) ;
une structure d'alignement (300) pour aligner les organes (141) et le substrat de circuit (142) dans une atmosphère, et
un dispositif chauffant (200) incorporant les organes (141) et le substrat de circuit (142) précédemment alignés et chauffant le matériau de soudage (20) entre les organes (141) et le substrat de circuit (142) dans une atmosphère non oxydante ou une atmosphère réductrice et solidarisant les organes (141) et le substrat de circuit (142) par soudage sans flux,
caractérisé en ce que
le dispositif de gravure par pulvérisation (100) comprend
des moyens (1000) pour détecter une émittance de particule depuis le matériau de soudage (20) du fait de la gravure par pulvérisation cathodique, et
des moyens pour mettre fin à la gravure par pulvérisation cathodique lorsque la quantité détectée de ces particules a atteint un niveau prédéterminé.
